# EUROPEAN PATENT SPECIFICATION

(11) **EP 3 928 162 B1**
(45) Date of publication and mention of the grant of the patent: **19.04.2023**
(21) Application number: 20705811.6
(22) Date of filing: 31.01.2020
(51) Int. Cl.: H01L 27/30, H01L 51/44, H01L 51/52, G03G 5/14, G03G 5/147

(54) **PHOTOELECTRIC CONVERSION ELEMENT, ORGANIC PHOTOCONDUCTOR, IMAGE FORMING METHOD, IMAGE FORMING APPARATUS, AND ORGANIC EL ELEMENT**
FOTOELEKTRISCHES UMWANDLUNGSELEMENT, ORGANISCHER FOTOLEITER, BILDERZEUGUNGSVERFAHREN, BILDERZEUGUNGSVORRICHTUNG UND ORGANISCHES EL-ELEMENT
ÉLÉMENT DE CONVERSION PHOTOÉLECTRIQUE, PHOTOCONDUCTEUR ORGANIQUE, PROCÉDÉ DE FORMATION D'IMAGE, APPAREIL DE FORMATION D'IMAGE ET ÉLÉMENT ÉLECTROLUMINESCENT ORGANIQUE

(30) Priority: 19.02.2019 JP 2019027352; 17.01.2020 JP 2020006105
(43) Date of publication of application: 29.12.2021
(73) Proprietor: Ricoh Company, Ltd., Tokyo 143-8555 (JP)
(72) Inventor: KAMI, Hidetoshi, Tokyo 143-8555 (JP); ASANO, Tomoharu, Tokyo 143-8555 (JP)
(74) Representative: Marks & Clerk LLP
(86) International application number: PCT/JP2020/003818
(87) International publication number: WO 2020/170769

(56) References cited:
- WO-A2-2010/071893
- JP-A- 2011 114 322
- JP-A- 2011 238 355
- US-A- 4 804 607
- US-A1- 2010 102 303

## Description

### Technical Field

The present disclosure relates to a photoelectric conversion element, an organic photoconductor, an image forming method, an image forming apparatus, and an organic EL element.

### Background Art

Conventionally, many of documents have been printed by electrophotographic devices, and the electrophotographic devices have been effectively used in various purposes. However, the number of opportunities for printing documents on paper media has been decreased year by year because of current trends of paper less and reduction in cost. Meanwhile, an expansion of use of an electrophotographic device from only office printing to commercial printing has been considered. Since electrophotography does not include a master production step, such as in offset printing, the electrophotography has an advantage that on-demand printing, where a various types of documents can be printed with the extremely small lot number, but in a large volume.

As a photoconductor used in an electrophotographic device, an organic photoconductor using an organic material has been widely used. Typically, an organic photoconductor includes a conductive support formed of aluminium etc., and a photoconductive layer including an organic compound where the photoconductive layer is disposed on the conductive support. An organic photoconductor has more advantages over an inorganic photoconductor because an organic photoconductor has excellent charging ability, materials thereof corresponding to various exposure light sources of from visible light to infrared light are easily developed, a material that does not pollute the environment can be selected for use, and a production cost thereof is low. However, an organic photoconductor also have disadvantages such that physical and chemical durability of an organic photoconductor is low and hence abrasions or scratches tend to formed after a long period of use.

Meanwhile, uniformity in printed products is important for commercial printing. Printed products printed by a conventional electrophotographic device have a problem that uniformity thereof is inferior to uniformity obtained in offset printing. Moreover, productivity and profitability are important for commercial printing compared with office printing. Therefore, it is important to keep a frequency of exchange of a photoconductor low. Currently, a service life of a photoconductor used in a top end model of an electrophotographic device is often set to about 1,000,000 prints. Even such service life is not sufficient as desirable durability for commercial printing.

PTL 1 has an object to provide an electrophotographic photoconductor having high sensitivity to a light source of a short wavelength light, and discloses an electrophotographic photoconductor including a support, and a charge-generating layer composed of metal oxide including nitrogen, where the charge-generating layer is disposed on the support.

However, the electrophotographic photoconductor disclosed in PTL 1 has a problem that durability bearable for commercial printing cannot be obtained.

As an element using the same technique as the photoelectric conversion in the electrophotographic photoconductor, an organic electroluminescence (EL) element has been known. The organic EL element is formed by laminating, on a substrate, a display element such as an organic EL light emitting layer sandwiched between an anode and a cathode. The organic EL display elements have a wider angle of visibility compared to liquid crystal display devices. In addition, the organic EL display elements have a rapid response speed, and are expected as the next generation display element because of its diversity of luminosity generated by organic matters.

However, the organic EL elements have the problems that they are easily deteriorated upon exposure to heat, moisture, or a gas such as oxygen, resulting in shortened lifetime of the organic EL elements.

### Citation List

### Patent Literature

PTL 1: Unexamined Japanese Patent Application Publication No. 2008-180937

### Summary of Invention

### Technical Problem

Accordingly, the present disclosure has an object to provide a photoelectric conversion element that has sufficient durability bearable for applications of commercial printing or display elements.

### Solution to Problem

According to one aspect of the present disclosure, a photoelectric conversion element includes: a support; a photoelectric conversion layer; an undercoat layer; and a surface layer. The photoelectric conversion layer, the undercoat layer, and the surface layer are disposed on or above the support in this order. The surface layer is a ceramic film. The undercoat layer includes a siloxane resin.

### Advantageous Effects of Invention

The present disclosure can provide a photoelectric conversion element that has sufficient durability bearable for applications of commercial printing or display elements.

### Brief Description of Drawings

[fig.1]FIG. 1 is a schematic cross-sectional view for describing an embodiment of a photoconductor of the present disclosure.
[fig.2]FIG. 2 is a schematic cross-sectional view for describing another embodiment of the photoconductor of the present disclosure.
[fig.3]FIG. 3 is a schematic cross-sectional view for describing another embodiment of the photoconductor of the present disclosure.
[fig.4]FIG. 4 is a schematic cross-sectional view for describing another embodiment of the photoconductor of the present disclosure.
[fig.5]FIG. 5 is a schematic cross-sectional view for describing another embodiment of the photoconductor of the present disclosure.
[fig.6]FIG. 6 is a schematic cross-sectional view for describing another embodiment of the photoconductor of the present disclosure.
[fig.7]FIG. 7 is a schematic view for describing an aerosol deposition device.
[fig.8]FIG. 8 is a schematic cross-sectional view for describing an embodiment of an organic EL element of the present disclosure.
[fig.9]FIG. 9 is a view for describing an embodiment of an image forming method and an image forming apparatus of the present disclosure.

### Description of Embodiments

Hereinafter, an embodiment of the present disclosure will be described in detail.

The photoelectric conversion element of the present disclosure includes a support, a photoelectric conversion layer, an undercoat layer, and a surface layer, where the photoelectric conversion layer, the undercoat layer, and the surface layer are disposed on or above the support in this order. The surface layer is a ceramic film, and the undercoat layer includes a siloxane resin.

### (Photoconductor)

First, one example of the case where the photoelectric conversion element of the present disclosure is a photoconductor will be described. In the case of a photoconductor, preferably, the photoelectric conversion layer is constituted as a photoconductive layer, and the support is constituted as a conductive support. The photoconductor of the present disclosure is preferably an organic photoconductor.

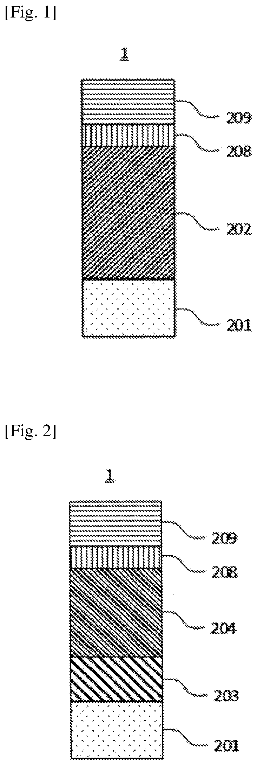

FIG. 1 is a schematic cross-sectional view for describing one embodiment of the photoconductor of the present disclosure.

In FIG. 1, the photoconductor 1 includes a conductive support 201, a photoconductive layer 202 disposed on the conductive support 201, and an undercoat layer 208 and a surface layer 209 sequentially disposed on the photoconductive layer 202. As described above, in the photoconductor 1 of the present disclosure, the surface layer 209 is a ceramic film, and the undercoat layer 208 includes a siloxane resin.

FIG. 2 is a schematic cross-sectional view for describing another embodiment of the photoconductor of the present disclosure.

The photoconductor 1 of FIG. 2 is a function-separation photoconductor, in which the photoconductive layer includes a charge-generating layer (CGL) 203, and a charge-transporting layer (CTL) 204.

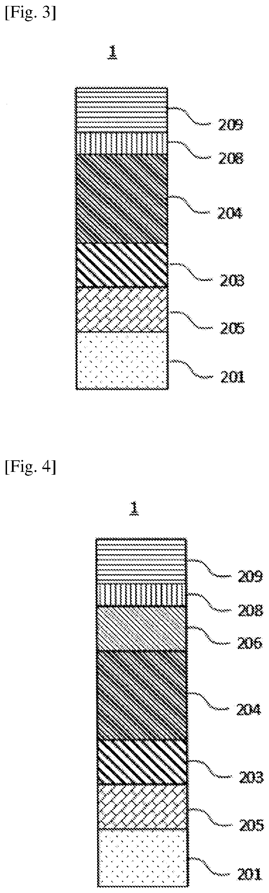

FIG. 3 is a schematic cross-sectional view for describing another embodiment of the photoconductor of the present disclosure.

The photoconductor 1 of FIG. 3 is an embodiment where an underlying layer 205 is disposed between the support 201 and the charge-generating layer (CGL) 203 in the function-separation photoconductor 1 illustrated in FIG. 2.

FIG. 4 is a schematic cross-sectional view for describing another embodiment of the photoconductor of the present disclosure.

The photoconductor 1 of FIG. 4 is an embodiment where a protective layer 206 is disposed on the charge-transporting layer (CTL) 204 on the function-separation photoconductor 1 illustrated in FIG. 3.

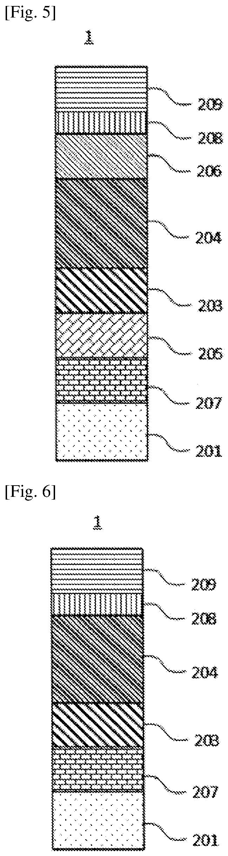

FIG. 5 is a schematic cross-sectional view for describing another embodiment of the photoconductor of the present disclosure.

The photoconductor 1 of FIG. 5 is an embodiment where an intermediate layer 207 is disposed between the support 201 and the underlying layer 205 in the phase-separation photoconductor 1 illustrated in FIG. 4.

The photoconductor of the present disclosure is not limited to each of the embodiments above, as long as the photoconductor includes at least the photoconductive layer on or above the support, the surface layer is a ceramic film, and the undercoat layer includes a siloxane resin.

As illustrated in FIG. 6, for example, the photoconductor may be a photoconductor 1, where an intermediate layer 207, a charge-generating layer 203, a charge-transporting layer 204, an undercoat layer 208, and a surface layer 209 formed of a ceramic semiconductor film are disposed on a conductive support 201 in this order.

The photoconductor of the present disclosure has excellent charging ability an organic photoconductor has. Since the surface layer is a ceramic film, the photoconductor of the present disclosure has excellent abrasion resistance equivalent to that of an inorganic photoconductor. Since the undercoat layer includes a siloxane resin, the photoconductor of the present disclosure has excellent gas barrier properties. Accordingly, the photoconductor of the present disclosure has excellent durability, and can yield excellent image quality.

Since the photoconductor includes the undercoat layer including a siloxane resin, particularly, the photoconductive layer, which has high gas permeability and low strength, can be densely covered with an inorganic film to enhance gas barrier properties. The under coat layer in the present disclosure has extremely high mechanical strength compared with an organic material, to significantly increase abrasion resistance of the photoconductor.

### <Photoconductive layer>

The photoconductive layer may be a multi-layer photoconductive layer, or a single-layer photoconductive layer.

### «Multi-layer photoconductive layer»

As described above, the multi-layer photoconductive layer includes at least a charge-generating layer, and a charge-transporting layer in this order, and may further include other layers according to the necessity.

### -Charge-generating layer-

The charge-generating layer includes at least a charge-generating material, further includes a binder resin, and may further include other components according to the necessity.

The charge-generating material is not particularly limited and may be appropriately selected depending on the intended purpose. As the charge-generating material, an inorganic material or an organic material may be used.

The inorganic material is not particularly limited and may be appropriately selected depending on the intended purpose. Examples thereof include crystalline selenium, amorphous-selenium, selenium-tellurium, selenium-tellurium-halogen, and a seleniumarsenic compound.

The organic material is not particularly limited and may be appropriately selected from materials known in the art depending on the intended purpose. Examples thereof include phthalocyanine-based pigments (e.g., metal phthalocyanine, and metal-free phthalocyanine), and azo pigments having a carbazole skeleton, a triphenylamine skeleton, a diphenylamine skeleton, or a fluorenone skeleton. The above-listed examples may be used alone or in combination.

The binder resin is not particularly limited and may be appropriately selected depending on the intended purpose. Examples thereof include a polyvinyl butyral resin, and a polyvinyl formal resin. The above-listed examples may be used alone or in combination.

Examples of a method for forming the charge-generating layer include vacuum thin-film formation, and casting from a solution dispersion-system.

Examples of an organic solvent used in the charge-generating layer coating liquid include methyl ethyl ketone, and tetrahydrofuran. The above-listed examples may be used alone or in combination.

A thickness of the charge-generating layer is, typically, preferably from 0.01 micrometers through 5 micrometers, and more preferably from 0.05 micrometers through 2 micrometers.

### -Charge-transporting layer-

The charge-transporting layer is a layer configured to hold electrification charge, and move charge generated in and separated from the charge-generating layer by exposure to combine with the held electrification charge. In order to hole electrification charge, it is important that the charge-transporting layer has high electrical resistance. In order to achieve high surface potential with the held electrification charge, moreover, it is important that the charge-transporting layer has a low dielectric constant, and good charge mobility.

The charge-transporting layer includes at least a charge-transporting material, further includes a binder resin, and may further include other components according to the necessity.

Examples of the charge-transporting material include a positive hole-transporting material, an electron-transporting material, and a polymer charge-transporting material.

Examples of the electron-transporting material (electron-accepting material) include 2,4,7-trinitro-9-fluorenone, and 1,3,7-trinitrodibenzothiophene-5,5-dioxide. The above-listed examples may be used alone or in combination.

Examples of the positive hole-transporting material (electron-donating material) include a triphenylamine derivative, and an α-phenylstilbene derivative. The above-listed examples may be used alone or in combination.

Examples of the polymer charge-transporting material include materials having the following structures. Examples thereof include a polysilylene polymer disclosed in Unexamined Japanese Patent Application Publication No. 63-285552, and a polymer having a triarylamine structure disclosed in Unexamined Japanese Patent Application Publication No. 09-304956.

As the binder resin, for example, a polycarbonate resin or a polyester resin is used. The above-listed examples may be used alone or in combination.

Note that, the charge-transporting layer may include a copolymer of a crosslinkable binder resin and a crosslinkable charge-transporting material.

The charge-transporting layer can be formed by dissolving or dispersing any of the above-mentioned charge-transporting materials and binder resins in an appropriate solvent, and applying and drying the resultant solution or dispersion. In addition to the charge-transporting material and the binder resin, an appropriate amount of additives, a plasticizer, an antioxidant, and a leveling agent, may be further added to the charge-transporting layer.

A thickness of the charge-transporting layer is preferably from 5 micrometers through 100 micrometers. A reduction in a thickness of a charge-transporting layer has been attempted to meet the current demands for high image quality. In order to achieve high image quality of 1,200 dpi or greater, the thickness thereof is more preferably from 5 micrometers through 30 micrometers.

### «Single-layer photoconductive layer»

The single-layer photoconductive layer includes a charge-generating material, a charge-transporting material, and a binder resin, and may further include other components according to the necessity.

As the charge-generating material, the charge-transporting material, and the binder resin, the same materials to those of the multi-layer photoconductive layer can be used.

When the single-layer photoconductive layer is formed by casting, in most of cases, the single-layer photoconductive layer is formed by dissolving or dispersing a charge-generating material, and low-molecular-weight and high-molecular-weight charge-transporting materials in an appropriate solvent, and applying and drying the resultant solution or dispersion. Moreover, the single-layer photoconductive layer may further include a plasticizer, and a binder resin according to the necessity. As the binder resin, the same binder resin to the binder resin of the charge-transporting layer may be used. As another binder resin, the binder resin may be further mixed with the same binder resin to the binder resin of the charge-generating layer.

A thickness of the single-layer photoconductive layer is preferably from 5 micrometers through 100 micrometers, and more preferably from 5 micrometers through 50 micrometers. When the thickness thereof is less than 5 micrometers, charging ability may be low. When the thickness thereof is greater than 100 micrometers, sensitivity may be low.

### <Support>

The support may be appropriately selected depending on the intended purpose, and those having conductivity can be used. Preferable examples of the support include conductors and conductively treated insulators. Examples thereof include: a support formed of a metal (e.g., Al, and Ni) or an alloy thereof; an insulating substrate (e.g., polyester, and polycarbonate) on which a thin film of metal (e.g., Al) or a conductive material (e.g., In₂O₃, and SnO₂) is formed; a resin substrate where carbon black, graphite, metal powder (e.g., Al, Cu, and Ni) or conductive glass powder is homogeneously dispersed in the resin to impart conductivity to the resin; and conductiontreated paper.

A shape and size of the support are not particularly limited. Any of a plate-shaped support, a drum-shaped support, or a belt type support can be used.

An underlying layer may be optionally disposed between the support and the photoconductive layer. The underlying layer is disposed for the purpose of improving adhesion, preventing moire, improving coatability of an upper layer, and decreasing residual potential.

The underlying layer typically includes a resin as a main component. Examples of the resin include: an alcohol-soluble resin, such as polyvinyl alcohol, copolymer nylon, and methoxymethylated nylon; and a curable resin that forms a three-dimensional network structure, such as polyurethane, a melamine resin, and an alkyd-melamine resin.

Moreover, powder of metal oxide (e.g., titanium oxide, silica, alumina, zirconium oxide, tin oxide, and indium oxide), metal sulfide, or metal nitride may be added to the underlying layer. The underlying layer can be formed by a commonly used coating method using an appropriate solvent.

A thickness of the underlying layer is not particularly limited and may be appropriately selected depending on the intended purpose. The thickness thereof is preferably from 0.1 micrometers through 10 micrometers, and is more preferably from 1 micrometers through 5 micrometers.

In the photoconductor of the present disclosure, a protective layer may be disposed on the photoconductive layer in order to protect the photoconductive layer. Examples of a material used for the protective layer include resins, such as ABS resins, ACS resins, olefin-vinyl monomer copolymers, chlorinated polyether, aryl resins, phenol resins, polyacetal, polyamide, polyamide imide, polyacrylate, polyallyl sulfone, polybutylene, polybutylene terephthalate, polycarbonate, polyether sulfone, polyethylene, polyethylene terephthalate, polyimide, acrylic resins, polymethylpentene, polypropylene, polyphenylene oxide, polysulfone, polystyrene, polyacrylate, AS resins, butadiene-styrene copolymers, polyurethane, polyvinyl chloride, polyvinylidene chloride, and epoxy resins.

As a formation method of the protective layer, conventional methods, such as dip coating, spray coating, bead coating, nozzle coating, spinner coating, and ring coating, can be used.

In the photoconductor of the present disclosure, an intermediate layer may be optionally disposed on the support in order to improve adhesion, and charge-blocking properties. The intermediate layer typically includes a resin as a main component. The resin is preferably a resin having high insolubility to a typical organic solvent because a photoconductive layer is applied thereon in the form of a solution including a solvent.

Examples of the resin include a water-soluble resin (e.g., polyvinyl alcohol, casein, and sodium polyacrylate), an alcohol-soluble resin (e.g., copolymer nylon, and methoxymethylated nylon, and a curable resin that forms a three-dimensional network structure (e.g., a polyurethane resin, a melamine resin, a phenol resin, an alkyd-melamine resin, and an epoxy resin).

### <Undercoat layer>

The undercoat layer includes a siloxane resin. The siloxane resin may be a resin that is formed by crosslinking an organic silica compound including a hydroxyl group or a hydrolyzable group.

The siloxane resin can fix the surface layer that is a ceramic film on a surface of the photoconductor, can enhance gas barrier properties of the photoconductor, and significantly enhance abrasion resistance of the photoconductor.

### -Siloxane resin-

The siloxane resin is formed by crosslinking an organic silicon compound having a hydroxyl group or a hydrolyzable group. The siloxane resin may further include a catalyst, a crosslinking agent, organosilica sol, a silane coupling agent, a polymer (e.g., an acryl polymer) etc., according to the necessity.

The crosslinking is not particularly limited and may be appropriately selected depending on the intended purpose. The crosslinking is preferably heat crosslinking.

Examples of the organic silicon compound including a hydroxyl group or a hydrolyzable group include a compound including an alkoxysilyl group, a partial hydrolysis condensate of a compound including an alkoxysilyl group, and a mixture thereof.

Examples of the compound including an alkoxysilyl group include: tetraalkoxysilane, such as tetraethoxysilane; alkyl trialkoxysilane, such as methyl triethoxysilane; and aryl trialkoxysilane, such as phenyl triethoxysilane. Moreover, any of the above-listed compounds, to which an epoxy group, a methacryloyl group, or a vinyl group is introduced, can be also used.

The partial hydrolysis of a compound including an alkoxysilyl group can be produced by a known method where a certain amount of water, a certain amount of a catalyst, etc. are added to the compound including an alkoxysilyl group to react.

As a raw material of the siloxane resin, a commercial product can be used. Specific examples thereof include GR-COAT (available from Daicel Corporation), Glass Resin (available from OWENS CORNING JAPAN LLC.), heatless glass (available from OHASHI CHEMICAL INDUSTRIES LTD.), NSC (available from NIPPON FINE CHEMICAL CO., LTD.), glass solution GO150SX and GO200CL (available from Fine Glass Technologies Co., Ltd.), and copolymers of an alkoxysilyl compound with an acrylic resin or polyester resin, such as MKC silicate (available from Mitsubishi Chemical Corporation) and silicate/acryl varnish XP-1030-1 (available from Aica Kogyo Company, Limited.).

A thickness of the undercoat layer is preferably 0.01 micrometers or more but 4.0 micrometers or less, more preferably 0.03 micrometers or more but 4.0 micrometers or less, still more preferably 0.05 micrometers or more but 2.5 micrometers or less. The thickness thereof is preferably 0.1 micrometers or more. Among them, the thickness thereof is particularly preferably 0.01 micrometers or more but 2.5 micrometers or less.

### <Surface layer>

The surface layer of the photoconductor of the present disclosure is a ceramic film. The ceramic constituting the ceramic film is typically a metal compound obtained by firing metal. The ceramic is not particularly limited and may be appropriately selected depending on the intended purpose. Examples thereof include metal oxide, such as titanium oxide, silica, alumina, zirconium oxide, tin oxide, and indium oxide. The ceramic preferably includes transparent conductive oxide. The transparent conductive oxide is preferably a ceramic semiconductor.

### <<Ceramic semiconductor>>

The ceramic semiconductor is a ceramic having a partial deficiency in a typical electron configuration thereof due to oxygen deficiency, etc., and a collective name of compounds that exhibit conductivity under certain conditions due to a deficiency of the electron configuration. The surface layer for use in the present disclosure is preferably a ceramic semiconductor film. The ceramic semiconductor film is defined as a layer that exhibits conductivity under certain conditions due to a deficiency of the electron configuration, a layer in which a ceramic semiconductor component is arranged densely without much space, and a layer that does not include an organic compound. The ceramic semiconductor film preferably includes delafossite. In the present disclosure, moreover, the ceramic semiconductor film preferably has charge mobility of holes or electrons. The charge mobility of the ceramic semiconductor film at the field intensity of 2 × 10⁻⁴ V/cm is preferably 1 × 10⁻⁶ cm²/Vsec or greater. In the present disclosure, the higher charge mobility is more preferable. A measuring method of the charge mobility is not particularly limited and may be appropriately selected from general measuring methods according to the intended purpose. Examples thereof include a method where production of a sample and a measurement are performed by the method disclosed in Unexamined Japanese Patent Application Publication No. 2010-183072.

Moreover, bulk resistance including a thickness of the ceramic semiconductor film is preferably less than 1 × 10¹³ Ω.

### -Delafossite-

The delafossite (may be referred to as a "p-type semiconductor" or "p-type metal compound semiconductor" hereinafter) is not particularly limited and may be appropriately selected depending on the intended purpose, as long as the delafossite has a function as a p-type semiconductor. Examples thereof include a p-type metal oxide semiconductor, a p-type compound semiconductor including monovalent copper, and other p-type metal compound semiconductors. Examples of the p-type metal oxide semiconductor include CoO, NiO, FeO, Bi₂O₃, MoO₂, MoS₂, Cr₂O₃, SrCu₂O₂, and CaO-Al₂O₃. Examples of the p-type compound semiconductor including monovalent copper include CuI, CuInSe₂, Cu₂O, CuSCN, CuS, CuInS₂, CuAlO, CuAlO₂, CuAlSe₂, CuGaO₂, CuGaS₂, and CuGaSe₂. Examples of other p-type metal compound semiconductor include GaP, GaAs, Si, Ge, and SiC.
In view of improvement of an effect obtainable by the present disclosure, the delafossite is preferably copper aluminium oxide, and the copper aluminium oxide is more preferably CuAlO₂.

### (Production of ceramic film)

A production method (film formation method) of the ceramic film is nor particularly limited and may be appropriately selected from generally used film formation methods of inorganic materials depending on the intended purpose. Examples thereof include a vapor deposition method, liquid deposition method, and a solid deposition method. The vapor deposition method is classified, for example, into physical vapor deposition (PVD) and chemical vapor deposition (CVD). Examples of the physical vapor deposition include vacuum vapor deposition, electron beam vapor deposition, laser abrasion, laser abrasion MBE, MOMBE, reactive vapor deposition, ion plating, cluster ion beam irradiation, glow discharge sputtering, ion beam sputtering, and reactive sputtering. Examples of the chemical vapor deposition method include thermal CVD, MOCVD, RF plasma CVD, ECR plasma CVD, photo CVD, and laser CVD. Examples of the liquid deposition method include LPE, electroplating, electroless plating, and coating. Examples of the solid deposition include SPE, recrystallization, graphoepitaxy, the LB technique, the sol-gel process, and aerosol deposition (AD).

Among the above-listed examples, AD is preferable because a uniform film can be formed over a relatively large area region, such as an electrophotographic photoconductor, and AD does not adversely affect properties of the electrophotographic photoconductor.

### -Aerosol deposition (AD)-

The aerosol deposition (AD) is a technique where particles or microparticles are mixed with gas to turn into aerosol, and the aerosol is ejected from a nozzle to a target on which a film is formed (substrate) to form a film. AD can form a film in a room temperature environment, and can form a film in a state where a crystal structure of a raw material is substantially maintained as it is. Therefore, AD is suitable for film formation on a photoelectric conversion device (particularly, electrophotographic photoconductor).

A method for forming the ceramic film according to the aerosol deposition will be described.

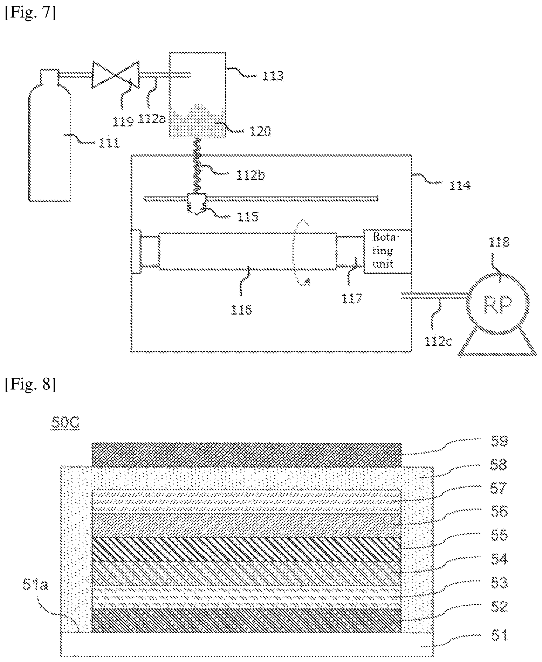

FIG. 7 is a schematic view for describing an aerosol deposition device.

Inert gas for generating aerosol is stored in a gas cylinder 111 illustrated in FIG. 7. The gas cylinder 111 is linked with an aerosol generator 113 via a pipe 112a, and the pipe112a is drawn into the aerosol generator 113. A certain amount of particles 120, which are a material for forming a ceramic film in the present disclosure, is placed inside the aerosol generator 113. The other pipe 112b linked with the aerosol generator 113 is connected to a jet nozzle 115 inside a film formation chamber 114.

Inside the film formation chamber 114, a substrate 116 is held with a substrate holder 117 to face the jet nozzle 115. As the substrate 116, an aluminium foil (positive electrode collector) is used. To the film formation chamber 114, an exhaust pump 118 for adjusting the degree of vacuum inside the film formation chamber 114 is connected via a pipe 112c.

Although it is not illustrated, disposed is a system for moving the substrate holder 117 in the cross direction (cross direction in the plane of the substrate holder 117 facing the jet nozzle 115) to move the jet nozzle 115 in the longitudinal direction (longitudinal direction in the plane of the substrate holder 117 facing the jet nozzle 115) at constant speed. A ceramic film having a desired area can be formed on the substrate 116 by performing film formation with moving the substrate holder 117 in the cross direction and the jet nozzle 115 in the longitudinal direction.

In the step for forming the ceramic film, first, the compressed air valve 119 is closed, and the atmosphere of from the film formation chamber 114 to the aerosol generator 113 is vacuumed by the exhaust pump 118. Next, the gas inside the gas cylinder 111 introduced into the aerosol generator 113 via the pipe 112a by opening the compressed air valve 119, and the particles 120 are sprinkled inside the container to generate aerosol in which the particles 120 are dispersed in the gas. The generated aerosol was ejected from the jet nozzle 115 to the substrate 116 via the pipe 112b at high speed. After passing 0.5 seconds with the compressed air valve 119 opened, the compressed air valve 119 is closed for the next 0.5 seconds. Then, the compressed air valve 119 is opened again, and the opening and closure of the compressed air valve 119 is repeated with a cycle of 0.5 seconds. The flow rate of the gas from the gas cylinder 111 is set to 2 L/min, and the film formation duration is 7 hours. The degree of vacuum inside the film formation chamber 114 when the compressed air valve 119 is closed is set to about 10 Pa, and the degree of vacuum inside the film formation chamber 114 when the compressed air valve 119 is closed is set to about 100 Pa.
The ejection speed of the aerosol is controlled by the shape of the jet nozzle 115, the length of inner diameter of the pipe 112b, the internal gas pressure of the gas cylinder 111, or displacement of the exhaust pump 118 (internal pressure of the film formation chamber 114). In the case where the internal pressure of the aerosol generator 113 is set to several ten thousands Pa, the internal pressure of the film formation chamber 114 is set to several hundreds Pa, and the shape of the opening of the nozzle 115 is a circle having an inner diameter of 1 mm, for example, the ejection speed of the aerosol can be made several hundreds m/sec due to a difference in internal pressure between the aerosol generator 113 and the film formation chamber 114. When the internal pressure of the film formation chamber 114 is maintained from 5 Pa through 100 Pa, and the internal pressure of the aerosol generator 113 is maintained to 50,000 Pa, a ceramic film having porosity of from 5% through 30% can be formed. The average thickness of the ceramic film can be adjusted by adjusting the duration for supplying the aerosol under the above-described conditions.

A thickness of the ceramic film is preferably from 0.1 micrometers through 10 micrometers, and more preferably from 0.5 micrometers through 5.0 micrometers.

The particles 120, the speed of which are accelerated to receive kinetic energy, in the aerosol are crushed into a photoconductor that is a substrate 116 to finely pulverize the particles with the impact energy. A ceramic film is sequentially formed on the charge-transporting layer by allowing the pulverized particles to adjoin the substrate (photoconductor) 116 and allowing the pulverized particles to adjoin one another.

The film formation is performed with a plurality of line patterns and rotations of the photoconductor drum. A ceramic film having a desired area is formed by scanning the substrate holder 117 or the jet nozzle 115 in a longitudinal direction and a cross direction of a surface of the substrate (photoconductor) 116.

### (Organic EL element)

Hereinafter, one example of the case where the photoelectric conversion element of the present disclosure is an organic electroluminescence (EL) element will be described. Note that, the aforementioned description can also be applied to the organic EL element of the present embodiment. Here, when the organic EL element of the present embodiment is described below, the following description takes priority.

The organic EL element of the present disclosure has a function of gas barrier, particularly a function of moisture barrier and has an excellent durability because the surface layer is a ceramic film. In addition, inclusion of a siloxane resin in the undercoat layer results in an improved gas barrier property and more excellent durability and can improve quality of a display image. In particular, when the organic EL element includes the undercoat layer including the siloxane resin, an organic EL layer having a large gas permeability and a weak strength can be covered with an inorganic film having compactness and can enhance a gas barrier property.

FIG. 8 is a schematic cross-sectional view for describing an embodiment of an organic EL element of the present disclosure. An organic EL element 50C of the present embodiment has a laminated structure obtained by disposing a support 51, a cathode 52, an electron injecting layer 53, an electron transporting layer 54, a light emitting layer 55, a hole transporting layer 56, an undercoat layer 57, a surface layer 58, and an anode 59 in this order. Note that, a reverse layer structure of an organic EL element that is advantageous in terms of durability is regarded as a standard element configuration in the present disclosure, but the present invention is not limited to this configuration.

### <Support>

When the photoelectric conversion element is used as an organic EL element, the support 51 may be constituted as a substrate. The support is preferably formed of an insulating substrate. The support may be, for example, a plastic substrate or a film substrate.

A barrier film may be disposed on a principal surface 51a of the support 51. The barrier film may be, for example, a film formed of silicon, oxygen, and carbon, or a film formed of silicon, oxygen, carbon, and nitrogen. Examples of a material of the barrier film include silicon oxide, silicon nitride, and silicon oxynitride. An average thickness of the barrier film is preferably 100 nm or more but 10 micrometers or less.

### <Organic EL layer>

When the photoelectric conversion element is used as an organic EL element, the photoelectric conversion layer may be constituted as an organic EL layer.

The organic EL layer includes, for example, a light emitting layer, and is a function part contributing to emission of the light emitting layer such as transfer of carriers and combination of carriers depending on voltage applied to the anode and the cathode. The organic EL layer may include, for example, the electron injecting layer 53, the electron transporting layer 54, the light emitting layer 55, and the hole transporting layer 56. The organic EL layer including electrodes such as a cathode and an anode may be referred to as an organic EL layer according to circumstances.

### «Electron injecting layer»

The electron injecting layer 53 may be disposed as a layer that decreases obstacle to electron injection from the cathode 52 to the electron transporting layer 54 formed of an organic material having a small electron affinity. Examples of a material used in the electron injecting layer 53 include: metal oxides including, for example, magnesium, aluminium, calcium, zirconium, silicon, titanium, and zinc; and polyphenylene vinylene, hydroxyquinoline, and naphthalimido derivatives.

An average thickness of the electron injecting layer 53 is preferably from 5 nm through 1000 nm, more preferably from 10 nm through 30 nm. The thickness can be measured through the spectroscopic ellipsometry, a surface roughness tester, or the microscopic image analysis.

### «Electron transporting layer»

Examples of a low-molecular-weight compound that can be used as a material of the electron transporting layer 54 include oxazole derivatives, oxadiazole derivatives, pyridine derivatives, quinoline derivatives, pyrimidine derivatives, pyrazine derivatives, phenanthroline derivatives, triazine derivatives, triazole derivatives, imidazole derivatives, tetracarboxylic acid anhydride, various metal complexes exemplified by, for example, tris(8-hydroxyquinolinato)aluminium (Alq₃), and silole derivatives. These may be used alone or in combination. Among them, metal complexes such as Alq₃ and pyridine derivatives are preferable.

An average thickness of the electron transporting layer 54 is preferably from 10 nm through 200 nm, more preferably from 40 nm through 100 nm. The thickness can be measured through the spectroscopic ellipsometry, a surface roughness tester, or the microscopic image analysis.

### «Light emitting layer»

Examples of a high polymer material of which the light emitting layer 55 is formed include polyparaphenylene vinylene-based compounds, polyfluorene-based compounds, and polycarbazole-based compounds.

Examples of a low molecular material of which the light emitting layer 55 is formed include metal complexes (e.g., tris(8-hydroxyquinolinato)aluminium (Alq₃), tris(4-methyl-8 quinolinolate)aluminium(III) (Almq₃), 8-hydroxyquinoline zinc (Znq₂), (1,10-phenanthroline)-tris-(4,4,4-trifluoro-1 -(2-thienyl)-butane-1,3-dionate)europium(I II) (Eu(TTA)₃(phen)), and 2,3,7,8,12,13,17,18-octaethyl-21H,23H-porphine platinum(II)), metal complexes (e.g., bis[2-(o-hydroxyphenyl benzothiazole]zinc(II) (ZnBTZ₂) and bis[2-(2-hydroxyphenyl)-pyridine]beryllium (Bepp₂)), metal complexes (e.g., tris[3-methyl-2-phenylpyridine]iridium(III) (Ir(mpy)₃)), distyrylbenzene derivatives, phenanthrene derivatives, perylene-based compounds, carbazole-based compounds, benzimidazole-based compounds, benzothiazole-based compounds, coumarin-based compounds, perinone-based compounds, oxadiazole-based compounds, quinacridone-based compounds, pyridine-based compounds, and spiro compounds. These may be used alone or in combination.

An average thickness of the light emitting layer 55 is not particularly limited, and is preferably from 10 nm through 150 nm, more preferably from 20 nm through 100 nm. The thickness can be measured through the spectroscopic ellipsometry, a surface roughness tester, or the microscopic image analysis.

### «Hole transporting layer»

Examples of a material used in the hole transporting layer 56 include oxazole derivatives, oxadiazole derivatives, imidazole derivatives, triphenylamine derivatives, butadiene derivatives, 9-(p-diethylaminostyrylanthracene), 1,1-bis-(4-dibenzylaminophenyl)propane, styrylanthracene, styrylpyrazoline, phenylhydrazones, α-phenylstilbene derivatives, thiazole derivatives, triazole derivatives, phenazine derivatives, acridine derivatives, benzofuran derivatives, benzimidazole derivatives, and thiophene derivatives. Other examples thereof include polyarylamine, fluorene-arylamine copolymer, fluorene-bithiophene copolymer, poly(N-vinylcarbazole), polyvinylpyrene, polyvinylanthracene, polythiophene, polyalkylthiophene, polyhexylthiophene, poly(p-phenylenevinylene), polythienylenevinylene vinylene, pyrene formaldehyde resins, ethyl carbazoleformaldehyde resins, and derivatives thereof. These hole transporting substances may be used alone or in the form of a mixture of two or more kinds of the aforementioned hole transporting substances. Alternatively, the hole transporting substances may be used in the form of a mixture with another compound.

An average thickness of the hole transporting layer 56 is preferably from 10 nm through 150 nm, more preferably from 40 nm through 100 nm.

### <Undercoat layer>

The undercoat layer 57 can be the same as described above.

The undercoat layer 57 includes a siloxane resin. The undercoat layer 57 in the present embodiment may be constituted as a silicone hard coat.

### <Surface layer>

The surface layer 58 can be the same as described above. Even in the present embodiment, the surface layer 58 is a ceramic film. As illustrated herein, the surface layer 58 may be formed on a side of the organic EL element, but is not limited thereto.

The ceramic film in the organic EL element and a production method thereof can be appropriately changed and applied in addition to the ceramic film and the production method described above. For example, an anode may be formed on the ceramic film. The ceramic film may be formed on the cathode so as to embed the organic EL layer. The ceramic film may be formed so as to cover a side of, for example, the organic EL layer. Disposition of the ceramic film of the present embodiment makes it possible to impart a function of gas barrier, particularly a function of moisture barrier to the organic EL element.

### <Cathode>

As the cathode 52, for example, a single substance of a metal element (e.g., Li, Na, Mg, Ca, Sr, Al, Ag, In, Sn, Zn, or Zr) or an alloy thereof may be used. LiF as an electrode protecting film may be formed on the cathode in the same manner as in the case of the cathode. In addition, ITO, IZO, FTO, and aluminium are preferably used.

An average thickness of the cathode 52 is preferably from 10 nm through 500 nm, more preferably from 100 nm through 200 nm. The thickness can be measured through the spectroscopic ellipsometry, a surface roughness tester, or the microscopic image analysis.

### <Anode>

As the anode 59, for example, gold, silver, aluminium, and ITO are preferably used. The thickness can be measured through the spectroscopic ellipsometry, a surface roughness tester, or the microscopic image analysis. When it is formed through vacuum deposition, a crystal resonator film thickness meter can be used.

### (Image forming method and image forming apparatus)

The image forming method of the present disclosure includes at least: charging a surface of a photoconductor; exposing the charged surface of the photoconductor to light to form an electrostatic latent image; developing the electrostatic latent image with a developer to form a visible image; and transferring the visible image to a recording medium. The photoconductor is the photoconductor of the present disclosure.

The image forming apparatus of the present disclosure includes at least a photoconductor, a charging unit configured to charge a surface of the photoconductor, an exposing unit configured to expose the charged surface of the photoconductor to light to form an electrostatic latent image, a developing unit configured to develop the electrostatic latent image with a developer to form a visible image, and a transferring unit configured to transfer the visible image to a recording medium. The photoconductor is the photoconductor of the present disclosure.

The image forming method and image forming apparatus of the present disclosure may further include other steps and other units according to the necessity. Note that, the charging unit and the exposing unit may be collectively referred to as an electrostatic latent image forming unit.

An embodiment of the image forming method and image forming apparatus of the present disclosure will be described through an example thereof, hereinafter.

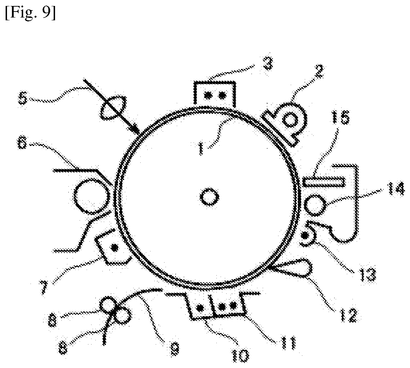

FIG. 9 is a schematic view for describing the image forming apparatus of the present disclosure. A charging unit 3, an exposing unit 5, a developing unit 6, a transferring unit 10, etc. are disposed at the periphery of a photoconductor 1. First, the photoconductor 1 is evenly charged by the charging unit 3. As the charging unit 3, a corotron device, a scorotron device, a solid discharge element, a multi-stylus electrode device, a roller charging device, or a conductive brush device is used, and a system known in the art can be used.

Next, an electrostatic latent image is formed on the uniformly charged photoconductor 1 by the exposing unit 5. As a light source of the exposing unit 5, any of general emitters, such as a fluorescent lamp, a tungsten lamp, a halogen lamp, a mercury lamp, a sodium vapor lamp, a light emitting diode (LED), a semiconductor laser diode (LD), and an electroluminescent (EL) element can be used. In order to emit only light of a desired wavelength range, moreover, various filters, such as a sharp-cut filter, a band-pass filter, a near infrared-cut filter, a dichroic filter, an interference filter, and a color temperature conversion filter, can be used.

Next, the electrostatic latent image formed on the photoconductor 1 is visualized by the developing unit 6. Examples of the developing system for use include a onecomponent developing method using a dry toner, a two-component developing method using a dry toner, and a wet developing method using a wet toner. When the photoconductor 1 is positively (negatively) charged and image exposure is performed, a positive (negative) electrostatic latent image is formed on a surface of the photoconductor. When the positive (negative) electrostatic latent image is developed with a toner (electrostatic particles) of negative (positive) polarity, a positive image is obtained. When the positive (negative) electrostatic latent image is developed with a toner (electrostatic particles) of positive (negative) polarity, a negative image is obtained.

Next, the toner image visualized on the photoconductor 1 is transferred by a transferring unit 10 to a recording medium 9 fed by a roller 8. Moreover, the pre-transfer charger 7 may be used to perform the transfer more smoothly. As the transferring unit 10, an electrostatic transfer system using a transfer charger, a bias roller, etc.; a mechanical transfer system, such as an adhesion transfer method, and a pressure transfer method; or a magnetic transfer system can be used.

As a unit for separating the recording medium 9 from the photoconductor 1, a separation charger 11 or a separation claw 12 may be optionally used. As other separation methods, electrostatic attraction induction separation, side-edge belt separation, top-edge griping separation, or curvature separation is used. As the separation charger 11, the charging unit can be used. In order to clean the toner remained on the photoconductor after the transferring, moreover, a cleaning unit, such as a fur brush 14, and a cleaning blade 15, can be used. In order to perform cleaning more effectively, a cleaning pre-charger 13 may be used. As other cleaning units, there are a wet system, and a magnet brush system. The above-listed systems may be used alone or in combination. Moreover, a charge-eliminating unit 2 may be used in order to eliminate the latent image on the photoconductor 1. As the charge-eliminating unit 2, a charge-eliminating lamp or a charge-eliminating charger is used. Any of the examples of the exposure light source and the charging unit can be used for the charge-eliminating unit. As other processes not performed near the photoconductor, such as paper feeding, fixing, and paper ejection, any of processes known in the art can be used.

### Examples

The present disclosure will be described in more detail by way of Examples and Comparative Examples. The present disclosure should not be construed as being limited to these Examples. Note that, "part(s)" described below means "part(s) by mass" unless otherwise stated.

### (Example 1)

### -Production example of electrophotographic photoconductor-

An electrophotographic photoconductor of Example 1 including an intermediate layer 207, a charge-generating layer 203, a charge-transporting layer 204, an undercoat layer 208, and a surface layer 209 formed of a ceramic semiconductor film disposed on a conductive support 201 in this order as illustrated in FIG. 6 was produced in the following manner.

### -Formation of intermediate layer-

The following intermediate layer coating liquid was applied on a conductive support (outer diameter: 60 mm) formed of aluminium by dip coating to form an intermediate layer. The average thickness of the intermediate layer after drying for 30 minutes at 170°C was 5 micrometers.

### (Intermediate layer coating liquid)

Zin oxide particles (MZ-300, available from TAYCA CORPORATION): 350 parts
3,5-di-t-butyl salicylate (TCI-D1947, available from Tokyo Chemical industry Co., Ltd.): 1.5 parts
Blocked isocyanate (SUMIJULE (registered trademark) 3175, solid content: 75% by mass, available from Sumitomo Bayer Urethane Co., Ltd.): 60 parts
Solution obtained by dissolving 20% by mass of a butyral resin in 2-butanone (BM-1, available from SEKISUI CHEMICAL CO., LTD.): 225 parts
2-Butanone: 365 parts

### -Formation of charge-generating layer-

The following charge-generating layer coating liquid was applied onto the obtained intermediate layer by dip coating to form a charge-generating layer. The average thickness of the charge-generating layer was 0.2 micrometers.

### (Charge-generating layer coating liquid)

Y-type titanyl phthalocyanine: 6 parts
Butyral resin (S-LEC BX-1, available from SEKISUI CHEMICAL CO., LTD.): 4 parts
2-Butanone (available from KANTO CHEMICAL CO., INC.): 200 parts

### -Formation of charge-transporting layer-

The following Charge-Transporting Layer Coating Liquid 1 was applied onto the obtained charge-generating layer by dip coating to form a charge-transporting layer. The average thickness of the charge-transporting layer after drying for 20 minutes at 135°C was 22 micrometers.

### (Charge-transporting layer coating liquid 1)

Bisphenol Z polycarbonate (PANLITE TS-2050, available from TEIJIN LIMITED): 10 parts
Low-molecular-weight charge-transporting material represented by Structural Formula (6) below: 10 parts

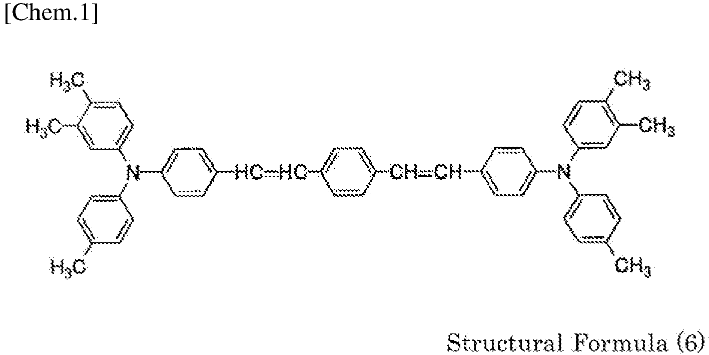

### Tetrahydrofuran: 80 parts

The following undercoat layer coating liquid was applied onto the obtained charge-transporting layer by dip coating to form an undercoat layer.

The average thickness of the undercoat layer after drying for 20 minutes at 135°C was 2 micrometers.

### (Undercoat layer coating liquid)

Curable siloxane resin (NSC-5506, available from NIPPON FINE CHEMICAL CO., LTD.): 80 parts
Tetrahydrofuran: 20 parts

### -Formation of Ceramic Film 1-

### (Copper aluminium oxide)

Copper(I) oxide (available from Wako Pure Chemical Industries, Ltd.): 40.014 g
Alumina (AA-03, available from SUMITOMO CHEMICAL COMPANY, LIMITED): 28.52 g

Copper aluminium oxide was prepared in the following manner. Copper(I) oxide and alumina were weighed and transferred to a mayonnaise bottle. The bottle was fixed on a sample stage of a vibration shaker (VIBRAX-VXR Basic, available from IKA), and was vibrated for 1 hour at the vibration intensity of 1,500 rpm to mix. The resultant was heated for 40 hours at 1,100°C to obtain copper aluminium oxide. The obtained copper aluminium oxide was pulverized by means of DRYSTAR SDA1 available from Ashizawa Fintech Ltd. to obtain powder having the number average particle diameter of 1 micrometer.

Next, Ceramic Film 1 was formed by means of a device as illustrated in FIG. 7 according to aerosol deposition.

As a film formation chamber, a modified device of a commercially available vapor deposition device (VPC-400, available from ULVAC) was used.

As an aerosol generator, a commercially available stirrer (T.K. AGI Homo MIXER 2M-03, PRIMIX Corporation) was used.

Note that, as the aerosol generator, a commercially available pressure feeding bottle (RBN-S, available from KSK) having a volume of 1 L disposed in an ultrasonic cleaner (SUS-103, available from Shimadzu Corporation) may be used.

A pipe having an inner diameter of 4 mm was drawn from the aerosol generator into the film formation chamber, and a jet nozzle (YB1/8MSSP37, available from SPRAYING SYSTEMS CO., JAPAN) was disposed at the tip of the pipe. A photoconductor was arranged at the position that was 2 mm away from the jet nozzle. As a photoconductor holder, a holder movable in a cross direction was used. As the jet nozzle, a nozzle movable in a longitudinal direction was used. An area of a film to be formed can be determined by moving the photoconductor holder and the jet nozzle. Meanwhile, the aerosol generator and a gas cylinder filled with nitrogen were linked with a pipe having an inner diameter of 4 mm.

By means of the above-described device, Ceramic Film 1 having the average thickness of 2.5 micrometers was produced in the following manner.

The aerosol generator was charged with 40 g of the copper aluminium oxide powder having the number average particle diameter of 1 micrometer. Next, the atmosphere of from the film formation chamber to the aerosol generator was vacuumed by the exhaust pump. Then, nitrogen gas was fed form the gas cylinder to the aerosol generator, and stirring was initiated to generate aerosol in which the particles were dispersed in the nitrogen gas. The generated aerosol was ejected from the jet nozzle to the photoconductor via the pipe. The flow rate of the nitrogen gas was from 13 L/min through 20 L/min. Moreover, the duration for film formation was 20 minutes, and the degree of vacuum inside the film formation chamber at the time of formation of Ceramic Film 1 was set to from about 50 Pa through about 150 Pa. A predetermined area of film formation was performed by moving the substrate holder and the jet nozzle.

As the number average particle diameter of the copper aluminium oxide, median of measured values obtained by measuring 5 times by means of MICROTRAC UPA-EX150, AVAILABLE FROM NIKKISO CO., LTD., using methanol as a dispersion medium, and with the measurement duration of 60 seconds.

### (Example 2)

A photoconductor was obtained in the same manner as in Example 1, except that the undercoat layer coating liquid was changed to the following undercoat layer coating liquid. The average thickness of the undercoat layer after drying for 20 minutes at 135°C was 0.5 micrometers.

### (Undercoat layer coating liquid)

Curable siloxane resin (NSC-5506, available from NIPPON FINE CHEMICAL CO., LTD.): 60 parts
Tetrahydrofuran: 40 parts

### (Example 3)

A photoconductor was obtained in the same manner as in Example 1, except that the undercoat layer coating liquid was changed to the following undercoat layer coating liquid. The average thickness of the undercoat layer after drying for 20 minutes at 135°C was 0.3 micrometers.

### (Undercoat layer coating liquid)

Curable siloxane resin (NSC-5506, available from NIPPON FINE CHEMICAL CO., LTD.): 50 parts
Tetrahydrofuran: 50 parts

### (Example 4)

A photoconductor was obtained in the same manner as in Example 1, except that the undercoat layer coating liquid was changed to the following undercoat layer coating liquid. The average thickness of the undercoat layer after drying for 20 minutes at 135°C was 2.5 micrometers.

### (Undercoat layer coating liquid)

Curable siloxane resin (NSC-5506, available from NIPPON FINE CHEMICAL CO., LTD.): 90 parts
Tetrahydrofuran: 10 parts

### (Example 5)

A photoconductor was obtained in the same manner as in Example 1, except that the undercoat layer coating liquid was changed to the following undercoat layer coating liquid. The average thickness of the undercoat layer after drying for 20 minutes at 135°C was 4 micrometers.

### (Undercoat layer coating liquid)

Curable siloxane resin (NSC-5506, available from NIPPON FINE CHEMICAL CO., LTD.): 100 parts

### (Example 6)

A photoconductor was obtained in the same manner as in Example 1, except that the undercoat layer coating liquid was changed to the following undercoat layer coating liquid. The average thickness of the undercoat layer after drying for 20 minutes at 135°C was 0.2 micrometers.

### (Undercoat layer coating liquid)

Curable siloxane resin (NSC-5506, available from NIPPON FINE CHEMICAL CO., LTD.): 40 parts
Tetrahydrofuran: 60 parts

### (Example 7)

A photoconductor was obtained in the same manner as in Example 1, except that the undercoat layer coating liquid was changed to the following Undercoat Layer Coating Liquid 1 to perform coating, and Undercoat Layer Coating Liquid 2 was applied onto Undercoat Layer Coating Liquid 1. The average thickness of the undercoat layer after drying for 20 minutes at 135°C was 5 micrometers.
(Undercoat Layer Coating Liquid 1)
Curable siloxane resin (NSC-5506, available from NIPPON FINE CHEMICAL CO., LTD.): 75 parts
Tetrahydrofuran: 25 parts
(Undercoat Layer Coating Liquid 2)
Curable siloxane resin (NSC-5506, available from NIPPON FINE CHEMICAL CO., LTD.): 100 parts

### (Comparative Example 1)

A photoconductor was obtained in the same manner as in Example 1, except that formation of the undercoat layer was omitted. The ceramic film after the film formation was a powder compact that could be broken off by simply scratching with finger nails, and the ceramic film could not be formed.

### <Evaluation of electrophotographic photoconductor>

The electrophotographic photoconductors of Examples 1 to 7 and Comparative Example 1 produced in the above-described manner were evaluated as follows. The evaluation results of each of the electrophotographic photoconductors are presented in Table 1.

### <<Image evaluation after NO₂ exposure>>

First, the electrophotographic photoconductor was left to stand in the NO₂ atmosphere for a certain period to allow NO₂ to be adsorbed on a surface of the electrophotographic photoconductor. As a result of researches on the conditions where adsorption sites near the surface of the electrophotographic photoconductor were saturated with NO₂ using various electrophotographic photoconductors, it was found that exposure in the camber the concentration of which was controlled to 40 ppm for 24 hours was preferable. Therefore, the exposure conditions were set to have the NO₂ concentration of 40 ppm, and the exposure duration of 24 hours.

Moreover, an image evaluation after NO₂ exposure was performed by means of a modified device of Ricoh Pro C9110 (available from Ricoh Company Limited) that had been modified to eliminate an initial idle process at the time of image output, using Protoner Black C9100, and using A3 size copy paper (POD gloss coat, available from Oji Paper Co., Ltd.) as a sheet. Moreover, the abrasion amount of the surface of the photoconductor after printing 5,000,000 sheets was measured.

As an output image, a half tone image was continuously output on 3 sheets after printing 0 sheets, 500,000 sheets, or 5,000,000 sheets of a pattern for evaluation. The dot reproduction state of the output image on the 3 sheets was observed with naked eyes and under a microscope. The results were evaluated based on the following evaluation criteria.

### (Evaluation criteria)

Good: There was no change in the dot reproduction state of the output image on the 3 sheets and there was no problem.
Fair: There was a slight change in the dot reproduction state of the output image on the 3 sheets, but there was no problem on practical use.
Poor: There was a significant concentration change in the dot reproduction state of the output image on the 3 sheets.

**[Table 1]**

| | Image evaluation after 0 sheets | Image evaluation after 500,000 sheets | Image evaluation after 5,000,000 sheets | Abrasion amount (µm) after 5,000,000 sheets |
|---|---|---|---|---|
| Ex. 1 | Good | Good | Good | 1.5 |
| Ex. 2 | Good | Good | Good | 1.7 |
| Ex. 3 | Good | Good | Fair | 2.5 |
| Ex. 4 | Good | Good | Good | 1.5 |
| Ex. 5 | Good | Fair | Fair | 1.2 |
| Ex. 6 | Fair | Fair | Fair | 2.5 |
| Ex. 7 | Fair | Fair | Fair | 1.2 |
| Comp. Ex. 1 | Good | Poor | Test terminated | Test terminated |

It was found from the results presented in Table 1 that the electrophotographic photoconductors obtained in Examples 1 to 7 could obtain stable image quality even after the NO₂ exposure and had excellent durability. Moreover, it was found that the thickness of the undercoat layer affected durability, and the film thickness of Examples 1, 2, and 4 was preferable.

### (Example 8)

The organic EL element presented in FIG. 8 was produced in the following manner. An SiO₂ layer was used as an underlying layer, and a film of indium-tin oxide (ITO) was formed on a glass substrate (support 51) through the sputtering method so that the surface resistance thereof would be 15 Ω/□, to form a cathode 52. Then, the substrate was cleaned sequentially with a neutral detergent, an oxygen-based cleaning agent, and isopropyl alcohol.

Then, ITZO as a target was subjected to sputtering by introducing argon and oxygen under the vacuum condition of 1 × 10⁻⁴ Pa, to form an electron injecting layer 53 having a thickness of 20 nm. Then, it was subjected to ultrasonic cleaning with acetone and isopropyl alcohol for 10 minutes, and was sprayed with nitrogen gas to be dried. Then, the resultant was cleaned with UV ozone for 10 minutes.

In the vacuum deposition apparatus, tris(8-quinolinolato)aluminium (Alq₃) (20 nm) as an electron transporting layer 54 and the following Structural Formula (B) (15 nm) as a light emitting layer 55 were deposited under vacuum.

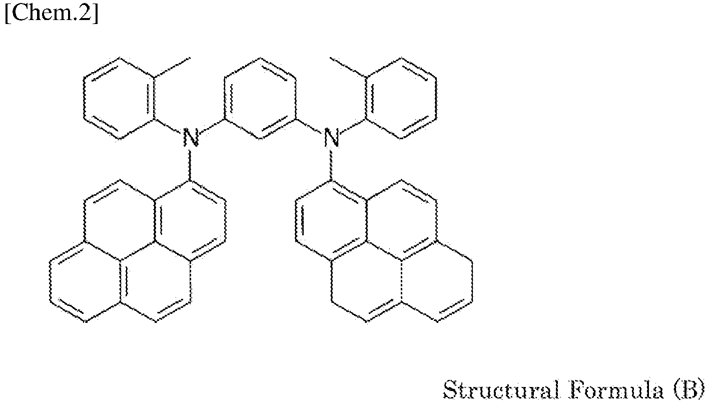

Then, as a hole transporting material of the following Structural Formula (C) was deposited thereon under vacuum to thereby form a hole transporting layer 56 having a thickness of 20 nm. As described above, the organic EL layer including the electron injecting layer 53, the electron transporting layer 54, the light emitting layer 55, and the hole transporting layer 56 was formed.

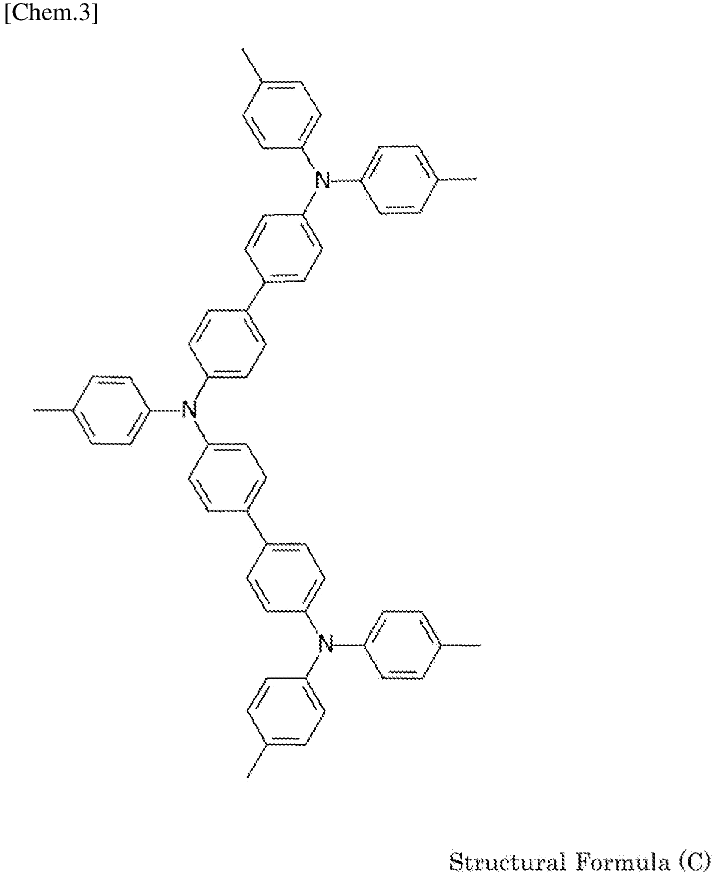

A film of a silicone hard coat (curable siloxane resin, NSC-5506, available from NIPPON FINE CHEMICAL CO., LTD.) having a thickness of 100 nm was formed through the inkjet method to thereby form an undercoat layer 57. An inkjet head GEN3E2 (available from Ricoh Industry Company, Ltd.) was used for the inkjet. The drawing frequency was set to 310 Hz, and a distance between the head and the substrate was set to 1 mm. The pulse voltage was set to 20 V. After the film formation, the film was subjected to a heating treatment of 80°C for 5 minutes.

A film of copper aluminium oxide (CuAlO₂) having a thickness of 40 nm was formed through the aerosol deposition method to thereby form a surface layer 58. Furthermore, an anode 59 formed of an ITO film having a thickness of 150 nm was formed through the sputtering method, to thereby obtain an organic EL element.

### (Comparative Example 2)

An organic EL element was obtained in the same manner as in Example 8 except that the silicone hard coat (undercoat layer 57) was not formed.

The organic EL element obtained in Example 8 was stored under the following conditions: atmosphere of NO₂ concentration of 20 ppm; and exposure time of 24 hours. Then, a lead wire was coupled to the anode and the cathode of the element, and the element was driven under the following conditions: a current density of 30 mA/cm² upon application of voltage; and a duty ratio of 50% so that on/off was repeated in a 10-msec cycle by a DC pulse power source. As a result, the initial luminance was 200 cd/m². The light emission luminance after continuous light emission for 46 hours was maintained at 50% or more of the initial luminance.

The organic EL element obtained in Comparative Example 2 was evaluated in the same manner as in Example 8. As a result, the luminance after 46 hours was 10% or less of the initial luminance.

Therefore, the organic EL element obtained in Example 8 is found to be excellent in durability.

### Reference Signs List

1: photoconductor
2: charge-eliminating unit
3: charging unit
5: exposing unit
6: developing unit
7: pre-transfer charger
8: roller
9: recording medium
10: transferring unit
11: separation charger
12: separation claw
13: cleaning pre-charger
14: fur brush
15: cleaning blade
50C: organic EL element
51: support
52: cathode
53: electron injecting layer
54: electron transporting layer
55: light emitting layer
56: hole transporting layer
57: undercoat layer
58: surface layer
59: anode
111: gas cylinder
112a: pipe
112b: pipe
112c: pipe
113: aerosol generator
114: film formation chamber
115: jet nozzle
116: substrate (photoconductor)
117: substrate holder
118: exhaust pump
119: compressed air valve
120: particles
201: support
202: photoconductive layer
203: charge-generating layer
204: charge-transporting layer
205: underlying layer
206: protective layer
207: intermediate layer
208: undercoat layer
209: surface layer

## Claims

1. A photoelectric conversion element comprising:
a support;
a photoelectric conversion layer;
an undercoat layer; and
a surface layer, where the photoelectric conversion layer, the undercoat layer, and the surface layer are disposed on or above the support in this order,
wherein the surface layer is a ceramic film, and
wherein the undercoat layer includes a siloxane resin.

2. The photoelectric conversion element according to claim 1,
wherein the undercoat layer and the surface layer are in contact with each other.

3. The photoelectric conversion element according to claim 1 or 2,
wherein a thickness of the undercoat layer is 0.01 micrometers or greater but 2.5 micrometers or less.

4. The photoelectric conversion element according to any one of claims 1
to 3,
wherein the ceramic film includes transparent conductive oxide.

5. The photoelectric conversion element according to claim 4,
wherein the transparent conductive oxide includes delafossite.

6. The photoelectric conversion element according to claim 5,
wherein the delafossite includes copper aluminium oxide.

7. The photoelectric conversion element according to claim 6,
wherein the copper aluminium oxide is CuAlO₂.

8. An organic photoconductor comprising
the photoelectric conversion element according to any one of claims 1 to 7.

9. An image forming method comprising:
charging a surface of a photoconductor;
exposing the charged surface of the photoconductor to light to form an electrostatic latent image;
developing the electrostatic latent image with a developer to form a visible image; and
transferring the visible image to a recording medium,
wherein the photoconductor is the organic photoconductor according to claim 8.

10. An image forming apparatus comprising:
a photoconductor;
a charging unit configured to charge a surface of the photoconductor;
an exposing unit configured to expose the charged surface of the photoconductor with light to form an electrostatic latent image;
a developing unit configured to develop the electrostatic latent image with a developer to form a visible image; and
a transferring unit configured to transfer the visible image to a recording medium,
wherein the photoconductor is the organic photoconductor according to claim 8.

11. An organic EL element comprising
the photoelectric conversion element according to any one of claims 1 to 7.

## Patentansprüche

1. Fotoelektrisches Umwandlungselement, umfassend:
einen Träger;
eine fotoelektrische Umwandlungsschicht;
eine Grundierungsschicht; und
eine Oberflächenschicht, wo die fotoelektrische Umwandlungsschicht, die Grundierungsschicht, und die Oberflächenschicht in dieser Reihenfolge auf oder über dem Träger angeordnet sind,
wobei die Oberflächenschicht ein Keramikfilm ist, und
wobei die Grundierungsschicht ein Siloxanharz einschließt.

2. Fotoelektrisches Umwandlungselement nach Anspruch 1,
wobei die Grundierungsschicht und die Oberflächenschicht miteinander in Kontakt stehen.

3. Fotoelektrisches Umwandlungselement nach Anspruch 1 oder 2,
wobei eine Dicke der Grundierungsschicht 0,01 Mikrometer oder mehr, aber 2,5 Mikrometer oder weniger beträgt.

4. Fotoelektrisches Umwandlungselement nach einem der Ansprüche 1 bis 3,
wobei der Keramikfilm transparentes leitfähiges Oxid einschließt.

5. Fotoelektrisches Umwandlungselement nach Anspruch 4,
wobei das transparente leitfähige Oxid Delafossit einschließt.

6. Fotoelektrisches Umwandlungselement nach Anspruch 5,
wobei das Delafossit Kupferaluminiumoxid einschließt.

7. Fotoelektrisches Umwandlungselement nach Anspruch 6,
wobei das Kupferaluminiumoxid CuAlO₂ ist.

8. Organischer Fotoleiter, umfassend
das fotoelektrische Umwandlungselement nach einem der Ansprüche 1 bis 7.

9. Bilderzeugungsverfahren, umfassend:
Laden einer Oberfläche eines Fotoleiters;
Belichten der geladenen Oberfläche des Fotoleiters mit Licht, um ein elektrostatisches latentes Bild zu erzeugen;
Entwickeln des elektrostatischen latenten Bildes mit einem Entwickler, um ein sichtbares Bild zu erzeugen; und
Übertragen des sichtbaren Bildes auf ein Aufzeichnungsmedium,
wobei der Fotoleiter der organische Fotoleiter nach Anspruch 8 ist.

10. Bilderzeugungsvorrichtung, umfassend:
einen Fotoleiter;
eine Ladeeinheit, die dazu konfiguriert ist, eine Oberfläche des Fotoleiters zu laden;
eine Belichtungseinheit, die dazu konfiguriert ist, die geladene Oberfläche des Fotoleiters mit Licht zu belichten, um ein elektrostatisches latentes Bild zu erzeugen;
eine Entwicklungseinheit, die dazu konfiguriert ist, das elektrostatische latente Bild mit einem Entwickler zu entwickeln, um ein sichtbares Bild zu erzeugen; und
eine Übertragungseinheit, die dazu konfiguriert ist, das sichtbare Bild auf ein Aufzeichnungsmedium zu übertragen,
wobei der Fotoleiter der organische Fotoleiter nach Anspruch 8 ist.

11. Organisches EL-Element, umfassend
das fotoelektrische Umwandlungselement nach einem der Ansprüche 1 bis 7.

## Revendications

1. Élément de conversion photoélectrique comprenant :
un support ;
une couche de conversion photoélectrique ;
une sous-couche ; et
une couche de surface, où la couche de conversion photoélectrique, la sous-couche et la couche de surface sont disposées sur ou au-dessus du support dans cet ordre,
dans lequel la couche de surface est un film céramique, et
dans lequel la sous-couche inclut une résine siloxane.

2. Élément de conversion photoélectrique selon la revendication 1,
dans lequel la sous-couche et la couche de surface sont en contact l'une avec l'autre.

3. Élément de conversion photoélectrique selon la revendication 1 ou 2,
dans lequel une épaisseur de la sous-couche est de 0,01 micromètre ou plus, mais de 2,5 micromètres ou moins.

4. Élément de conversion photoélectrique selon l'une quelconque des revendications 1 à 3,
dans lequel le film céramique inclut de l'oxyde conducteur transparent.

5. Élément de conversion photoélectrique selon la revendication 4,
dans lequel l'oxyde conducteur transparent inclut de la delafossite.

6. Élément de conversion photoélectrique selon la revendication 5,
dans lequel la delafossite inclut de l'oxyde de cuivre et d'aluminium.

7. Élément de conversion photoélectrique selon la revendication 6,
dans lequel l'oxyde de cuivre et d'aluminium est CuAlO₂.

8. Photoconducteur organique comprenant
l'élément de conversion photoélectrique selon l'une quelconque des revendications 1 à 7.

9. Procédé de formation d'image comprenant:
le chargement d'une surface d'un photoconducteur ;
l'exposition de la surface chargée du photoconducteur à la lumière pour former une image latente électrostatique ;
le développement de l'image latente électrostatique avec un révélateur pour former une image visible ; et
le transfert de l'image visible sur un support d'enregistrement,
dans lequel le photoconducteur est le photoconducteur organique selon la revendication 8.

10. Appareil de formation d'image comprenant :
un photoconducteur ;
une unité de chargement configurée pour charger une surface du photoconducteur ;
une unité d'exposition configurée pour exposer la surface chargée du photoconducteur à la lumière pour former une image latente électrostatique ;
une unité de développement configurée pour développer l'image latente électrostatique avec un révélateur pour former une image visible ; et
une unité de transfert configurée pour transférer l'image visible à un support d'enregistrement,
dans lequel le photoconducteur est le photoconducteur organique selon la revendication 8.

11. Élément organique EL comprenant
l'élément de conversion photoélectrique selon l'une quelconque des revendications 1 à 7.
